# EUROPÄISCHE PATENTSCHRIFT

(11) **EP 1 502 156 B1**
(45) Veröffentlichungstag und Bekanntmachung des Hinweises auf die Patenterteilung: **16.11.2005**
(21) Anmeldenummer: 03749830.0
(22) Anmeldetag: 07.05.2003
(51) Int. Cl.: G03F 7/00, G03F 7/40, G02B 7/00

(54) **VERFAHREN ZUR HERSTELLUNG EINER EINHEIT MIT EINER RÄUMLICHEN OBERFLÄCHENSTRUKTURIERUNG SOWIE VERWENDUNG DIESES VERFAHRENS**
METHOD FOR PRODUCING A UNIT COMPRISING THREE-DIMENSIONAL SURFACE STRUCTURING AND USE OF SAID METHOD
PROCEDE DE PRODUCTION D'UNE UNITE COMPORTANT UNE STRUCTURATION SUPERFICIELLE TRIDIMENSIONNELLE ET UTILISATION DE CE PROCEDE

(30) Priorität: 08.05.2002 US 379102 P
(43) Veröffentlichungstag der Anmeldung: 02.02.2005
(73) Patentinhaber: Unaxis Balzers Aktiengesellschaft, 9496 Balzers (LI)
(72) Erfinder: GRABHER, Patrick, A-6900 Bregenz (AT); HEINE-KEMPKENS, Claus, CH-7000 Chur (CH); BISCHOFBERGER, Roger, CH-9471 Buchs (CH)
(74) Vertreter: Roshardt, Werner Alfred
(86) Internationale Anmeldenummer: PCT/CH2003/000296
(87) Internationale Veröffentlichungsnummer: WO 2003/096122

(56) Entgegenhaltungen:
- US-A- 5 246 803
- US-A- 5 360 698
- US-A- 5 510 215
- PATENT ABSTRACTS OF JAPAN vol. 2000, no. 14, 5. März 2001 (2001-03-05) & JP 2000 331918 A (TOKYO CATHODE LABORATORY CO LTD), 30. November 2000 (2000-11-30)

## Beschreibung

### Technisches Gebiet

Die Erfindung betrifft ein Verfahren ("Lift-Off-Verfahren") zur Herstellung einer Einheit mit einer räumlichen Oberflächenstrukturierung gemäss Patentanspruch 1 sowie eine Verwendung dieses Verfahrens gemäss Patentanspruch 13.

### Aufgabe der Erfindung

Aufgabe der vorliegenden Erfindung ist es ein Verfahren anzugeben, mit dem eine räumliche Oberflächenstrukturierung erzeugbar ist, ohne dass teure und schwierig zu handhabende Lösungsmittel eingesetzt werden müssen. Die Oberflächenstrukturen liegen vorzugsweise im Mikro- und Submikrometerbereich. Das Verfahren lässt sich jedoch auch bei einer gröberen Strukturierung verwenden.

### Lösung

Die Lösung der Aufgabe erfolgt durch die Merkmale des Patentanspruchs 1.

Erfindungsgemäss wird zur Herstellung einer Einheit mit einer räumlichen Oberflächenstrukturierung auf einer Grundschicht in einem ersten Verfahrensschritt ein Photolack zur Erzeugung einer Photolackschicht aufgebracht. In einem anschliessenden zweiten Verfahrensschritt wird eine, einer vorgegebenen Oberflächenstrukturierung angepasste, maskierte Belichtung der Photolackschicht vorgenommen. In einem dritten Verfahrensschritt werden mittels Entwicklung Teile der Photolackschicht entfernt, so dass eine Opferschichtgebiete aufweisende Oberflächenanfangsstrukturierung erhalten wird: Das Material der Opferschichtgebiete ist der verbleibende Photolack. In einem vierten Verfahrensschritt wird eine die nun erhaltene Oberflächenanfangsstrukturierung bedeckende Beschichtung aufgebracht. Die Eigenschaften dieser Oberflächenanfangsstrukturierung richten sich weitgehend nach den Erfordernissen bei der Verwendung der Einheit. Die Beschichtung kann eine einzige Schicht, aber auch eine Wechselschicht sein. Das Aufbringen kann durch Aufsprühen, mit einem CVD- oder mit einem PVD-Verfahren erfolgen. Bevorzugt wird man diese Beschichtung aufsputtem. An den vierten Verfahrensschritt schliesst sich ein fünfter Verfahrensschritt an, indem die Einheit eine Energiebeaufschlagung zur Destabilisierung der mit der Beschichtung bedeckten restlichen Opferschichtgebiete erfährt. Die Energiebeaufschlagung kann von der Vorder- wie auch von der Rückseite der Einheit, oder von beiden Seiten, erfolgen. Vorzugsweise wird man von der Rückseite der Einheit die Energiebeaufschlagung vornehmen. Die Rückseite ist in der Regel für die nachfolgend angeführten Energiebeaufschlagungsmethoden besser zugänglich als die Vorderseite der Einheit. Die Vorderseite der Einheit ist nämlich zur Erzeugung der Strukturierung laufend in Bearbeitung. In einem sechsten Verfahrensschritt wird die Vorderseite dann mit einem Hochdruckflüssigkeitsstrahl beaufschlagt. Da die Opferschichtgebiete unterhalb der Beschichtung durch die Energiebeaufschlagung destabilisiert sind, entfernt der Hochdruckflüssigkeitsstrahl diese Opferschichtgebiete samt der darüberliegender Beschichtung mechanisch und/oder bricht wenigstens die Beschichtung über den Opferschichtgebieten auf. Eine chemische und/oder physikalische Auflösungsgeschwindigkeit durch die Flüssigkeit des Hochdruckflüssigkeitsstrahls ist bei der gewählten Bearbeitungstemperatur vernachlässigbar d.h. sie liegt unterhalb einer Messgrenze. Die Materialien der Einheit sowie die Fluiddichtungsmittel der Verfahrensvorrichtung werden somit während der Beaufschlagung durch den Hochdruckflüssigkeitsstrahl nicht nachweisbar angegriffen. Unter Fluiddichtungsmitteln werden Materialien verstanden, welche z.B. in Fluidleitungen zum Abdichten in einer Vorrichtung zur Durchführung des erfindungsgemässen Verfahrens verwendet werden. Fluiddichtungsmittel sind z.B. O-Ringe, Dichtungsscheiben usw.

Durch die Energiebeaufschlagung sind die Opferschichtgebiete "mürbe" gemacht worden. Der Hochdruckflüssigkeitsstrahl dringt somit unter Aufreissen der Beschichtung über den Opferschichtgebieten in diese ein. Das "Einbrechen" bzw. "Eindringen" kann nun derart erfolgen, dass hierdurch jeweils ein Opferschichtgebiet vollständig entfernt (weggeschleudert) wird. Es kann aber auch nur ein teilweises Einbrechen erfolgen. Dieses Einbrechen ergibt jedoch räumlich bedeutend grössere Defekte als z. B. mit einer Beschallung im Ultraschallbad in wirtschaftlich vertretbarer Zeit erreichbar sind.

Die mit der Beschichtung bedeckten Opferschichtgebiete werden durch die Destabilisierung der Opferschichtgebiete entfernt, während die Bereiche der Beschichtung ohne Opferschichtgebiete, also die Grundschicht lediglich beschichtet mit der Beschichtung stehen bleiben. Die Höhen der Oberflächenanfangsstrukturierung sind nach dem Verfahren die Tiefen der Oberflächenendstrukturierung.

Bekannt war es Opferschichtgebiete durch ein Bespülen mit einer Flüssigkeit unter Aufquellen und einem chemischen und/oder physikalischen Auflösen zu entfernen. Die Erfindung hingegen verzichtet gerade auf ein chemisches und/oder physikalisches Auflösen. Bei der Erfindung werden nämlich Flüssigkeiten verwendet, deren chemische und physikalische Auflösungsgeschwindigkeit bei einer im Verfahren verwendeten Bearbeitungstemperatur mit Materialien der Einheit sowie in der Verfahrensvorrichtung verwendeten Fluiddichtungsmitteln während der Beaufschlagung unterhalb der Messgrenze liegen. Fluiddichtungsmittel wie Dichtringe und -scheiben bestehen in der Regel aus organischen Material. Die Erfindung verwendet ferner keine Materialien, welche mit der Umgebungsluft reagieren. Es müssen deshalb u.a. keine besonderen sicherheitstechnischen Vorkehrungen (Vermeidung einer Explosionsgefahr, schwierige Entsorgung, krebserregende Stoffe, ...), wie bei den bekannten Lösungsmitteln Aceton, Alkohol etc. vorgenommen werden. Auch kann der mechanische Aufbau einfacher und preisgünstiger gestaltet werden, da die zu verwendende Flüssigkeit des Hochdruckflüssigkeitsstrahls weder das Material einer für das Verfahren zu verwendenden Vorrichtung angreift, noch deren Dichtungsmittel. Als Dichtungsmittel können somit preisgünstige Massenartikel von Dichtungen, O-Ringen, Tellerdichtungen; ... verwendet werden, wie man sie beispielsweise im Haussanitärbereich einsetzt.

Erklärend sei erwähnt, dass gemäss "Römpp", 9. Auflage, Seite 2539, zwischen einer physikalischen und einer chemischen Auflösung unterschieden wird. Löst man z.B. Kochsalz oder Zucker in Wasser auf, so erhält man nach Eindampfen oder Eintrocknen der Lösung wieder die ganze vorher aufgelöste Stoffmenge unverändert zurück. Da sich bei diesem Auflösungsvorgang am Stoff Kochsalz bzw. Zucker nichts Wesentliches geändert hat, spricht man hier von einer physikalischen Auflösung.

Die chemische Auflösung hingegen ist an eine chemische Reaktion des festen Stoffes mit dem Lösungsmittel gebunden. Bei Entfemen des Lösungsmittels durch Eindampfen bleibt eine neue Substanz zurück. Übergiesst man beispielsweise Eisen mit Salzsäure, so löst sich das Eisen unter Gasentwicklung und Grünfärbung auf. Es hat sich hier nicht das Eisen, sondern das aufgrund eines chemischen Vorganges gebildete Eisen(II)-chlorid aufgelöst.

Unter einem Hochdruckflüssigkeitsstrahl wird ein Strahl verstanden, bei dem der Druck vor dem Austritt aus einer den Strahl formenden Düse einige zehn bar beträgt. Der Druck richtet sich nach dem Aufbau, den Schichtdicken, den flächigen Abmessungen, dem Material bzw. den Materialien sowie der Art der Überdeckung bei den zu entfernenden Strukturen. Der Druck des Hochdruckflüssigkeitsstrahls liegt zur Erzeugung der gewünschten Oberflächenstrukturen bei ca. 100 bar bis 180 bar.

Die Eigenschaften der Photolackschicht verändern sich durch Bestrahlung mit sichtbarer Strahlung bzw. Strahlung im nahen Ultraviolettbereich. Die Photoschicht kann aus einem photoempfindlichen Polymermaterial bestehen. Es gibt positive und negative photoempfindliches Material sowie auch sogenannte Bildumkehrlacke. Die Entwicklung der Photoschicht nach der Belichtung richtet sich nach dem verwendeten Schichtmaterial, der Schichtdicke und der Belichtungsintensität.

Die Photoschicht kann beispielsweise aus einem Bildumkehrlack mit einer Schichtdicke von 1,5 µm bis 10 µm bestehen. Die gewählte Schichtdicke sowie deren Material hängt von der Anwendung der herzustellenden strukturierten Beschichtung ab. Bei der beispielsweisen Herstellung eines strukturierten, optischen Farbfilters wird man mit Schichtdicken zwischen 3 µm bis 5 µm arbeiten und die Entwicklung der Schicht mit Natronlauge NaOH, welche eine Konzentration grösser 0,8% hat, vornehmen. Bei einem Bildumkehrlack arbeitet man vorzugsweise mit einer annähernd 1,2%-igen Natronlauge.

Der hier vorzugsweise verwendete Bildumkehrlack verbindet die Vorteile eines Positivlackes mit denjenigen eines Negativlackes. Der Bildumkehrlack wird hier zweimal belichtet, wobei die zweite Belichtung im Ultraviolettbereich mit einer Bestrahlung grösser 300 mJ/cm² erfolgt. Zwischen den beiden Belichtungen erfolgt vorzugsweise eine Erwärmung, d.h. ein "Aufbacken" mit einer Temperatur zwischen 110 °C und 130 °C. Die Werte für die Erwärmung hängen vom verwendeten Lackmaterial ab; hier wird beispielsweise ein Photolack mit der Bezeichnung Ti35E der Firma Micro Chemicals verwendet. Vorzugsweise wird eine möglichst hohe Temperatur verwendet, bei der der Photolack noch nicht zerfliesst, da dann das Aufbacken weniger lang dauert. Im hier beschriebenen Beispiel wird deshalb typischerweise eine Temperatur von 130 °C verwendet.

Durch den Hochdruckflüssigkeitsstrahl werden die mit der Beschichtung bedeckten, restlichen Opferschichtgebiete aufgebrochen und oftmals nicht vollständig entfernt. Für eine vollständige Entfernung noch verbliebener, eventuell teilweise bedeckter Opferschichtgebiete wird dann vorzugsweise in einem siebten Verfahrensschritt mit einem weiteren Zuführsystem, welches vom Hochdruckflüssigkeitsstrahl getrennt ist, ein Lösungsmittel, typischerweise Natronlauge NaOH mit einer Konzentration zwischen 1 % und 20 %, vorzugsweise zwischen 9,5 % und 10,5%, insbesondere von 10 % aufgebracht. Vorzugsweise wird man das Lösungsmittel direkt nachfolgend zum Hochdruckflüssigkeitsstrahl aufbringen. Durch die Verwendung von getrennten Zuführsystemen kann das Zuführsystem für das Lösungsmittel mit seinem Rohrleitungsmaterial und seinen Dichtungen speziell auf die Eigenschaften des Lösungsmittels ausgerichtet werden. Im Gegensatz zum Hochdruckflüssigkeitsstrahl wird das Lösungsmittel mit niedrigem Druck ("Plätscherstrahl") aufgebracht. Druckmässig sind somit an das Leitungssystem des Lösungsmittels keine besonderen Anforderungen zu stellen.

Die Destabilisierung der mit der oberen Schicht bedeckten restlichen Opferschichtgebiete im fünften Verfahrensschritt erfolgt durch eine Energiebeaufschlagung der gesamten Beschichtung. Je nach verwendeten Schichtmaterialien, insbesondere dem Material der alles bedeckenden Beschichtung, können die nachfolgenden Verfahren verwendet werden:
■ UV-Flutbelichtung beispielsweise mit 500 bis 1500 mJ/cm² während 4 bis 10 Minuten;
■ Kochen (typischerweise 1 bis 2 Stunden) in einer nicht angreifenden Flüssigkeit (z.B. Wasser);
■ Heissdampf (z. B. Wasserdampf mit 127 °C bei 2,5 bar) mit vemachlässigbarer chemischer Reaktionsgeschwindigkeit;
■ eine aufwärmende Mikrowellenstrahlung mit typischerweise 100 W und einer Dauer von 5 Minuten.

Die Beschichtung auf der entwickelten Photolackschicht wird entsprechend der Verwendung ausgewählt. Hier, bei einem beispielsweisen optischen Einsatz, handelt es sich um einen strukturierten dielektrischen Film (z.B. Farbfilter, insbesondere Farbräder). Die Beschichtung kann als Wechselschichtsystem z. B. aus einer Abfolge von optisch hoch- und niederbrechenden Schichten, aus wenigstens zwei unterschiedlichen Oxiden oder Oxinitriden aus den Gruppen IVA, IVB, VB des periodischen Systems ausgebildet werden. Als hochbrechendes Material kann man beispielsweise TiO₂, Ta₂O₅, Nb₂O₅, HfO₂, ZrO₂, SiOₓN_{y}, ... und als niedrig brechendes Material beispielsweise SiO₂, Al₂O₃, SiOₓN_{y}, verwenden. In diesem Fall wird man die obere Schicht mit einer Dicke zwischen 0,5 µm und 5 µm, vorzugsweise zwischen 1 µm und 2 µm herstellen. Das Aufbringen bzw. Aufsputtern dieser Wechselschicht im vierten Verfahrensschritt wird insbesondere bei einer Temperatur der Einheit unter 120 °C vorgenommen werden. Werden andere Materialien verwendet, ergeben sich auch andere Temperaturen. Ein Verfahren zur Herstellung einer derartigen Beschichtung ist z.B. in der DE-A 44 10 258 beschrieben.

Die Belichtung des Photolackes kann durch Abbilden einer Chrommaske auf der oberen Schicht erfolgen. Die Chrommaske wird man bevorzugt mit einer Quecksilberdampflampe (Emissionslinie bei 365 nm; Intensität 160 mJ/cm²) vornehmen. Man kann aber auch einen Laserstrahl verwenden, der über die obere Schicht entsprechend der gewünschten Struktur bewegt wird. Verwendet man einen Laserstrahl, so kann dessen Fokuspunkt derart eingestellt werden, dass er über, auf oder in der Photolackschicht liegt. Liegt ein kurzbrennweitiger Fokuspunkt z. B. auf der Photolackschicht, so divergiert die Laserstrahlung stark im Photolack. Tiefer liegende Bereiche des Photolacks werden dann weniger belichtet als Bereiche in unmittelbarer Oberflächennähe. Diese divergierende Belichtung unterstützt die Erzeugung überhängender Seitenwände bei der zu erzeugenden Struktur. Überhängende Wände führen zu einer Konfiguration, welche zusammen mit der oben erwähnten Destabilisierung ein leichteres Aufbrechen bzw. Entfernen der mit der oberen Schicht bedeckten restlichen Opferschichtbereiche mit dem Horhdruckflüssigkeitsstrahl gestattet.

Als Flüssigkeiten für den Hochdruckflüssigkeitsstrahl können nahezu alle Flüssigkeiten verwendet werden, deren chemische und physikalische Auftösungsgeschwindigkeit bei Normaltemperatur mit Materialien der Einheit sowie mit Fluiddichtungsmitteln während der Beaufschlagung unterhalb der Messgrenze liegt. Wird jedoch als Flüssigkeit für den Hochdruckflüssigkeitsstrahl DI-Wasser (entmineralisiertes, gefiltertes Wasser) mit einem Druck zwischen 100 bar und 180 bar verwendet, so wird die strukturierte Vorderseite gleichzeitig gereinigt und ist somit bereit für einen nächsten Verfahrensschritt z.B. für einem Lithographieprozess. Dies ergibt gegenüber den bekannten Verfahren eine zusätzliche Steigerung der Effizienz.

Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

Die zur Erläuterung der Ausführungsbeispiele verwendeten Zeichnungen zeigen in
- Fig. 1: einen Querschnitt durch eine Einheit mit einer Grundschicht, welche mit einer Photolackschicht bedeckt ist, die maskiert belichtet wird,
- Fig. 2: einen Querschnitt durch die in **Figur 1** dargestellte Einheit, nach einer Entwicklung der Photolackschicht mit einer nachfolgenden Beschichtung,
- Fig. 3: eine skizzenhafte Darstellung der erfindungsgemässen Entfernung der durch eine Energiebeaufschlagung destabilisierten, mit einer Beschichtung bedeckten Opferschichtgebiete (entwickelte Photolackschichtgebiete) und
- Fig. 4: einen Querschnitt durch die in **Figur 1** dargestellte Einheit nach sämtlichen Verfahrensschritten mit einer nun erzeugten Oberflächenendstrukturierung, wobei der Einfachheit halber lediglich ein von vielen möglichen erhabenen Gebieten der Struktur dargestellt ist.
Grundsätzlich sind in den Figuren gleiche Teile und Elemente mit gleichen Bezugszeichen versehen.

### Wege zur Ausführung der Erfindung

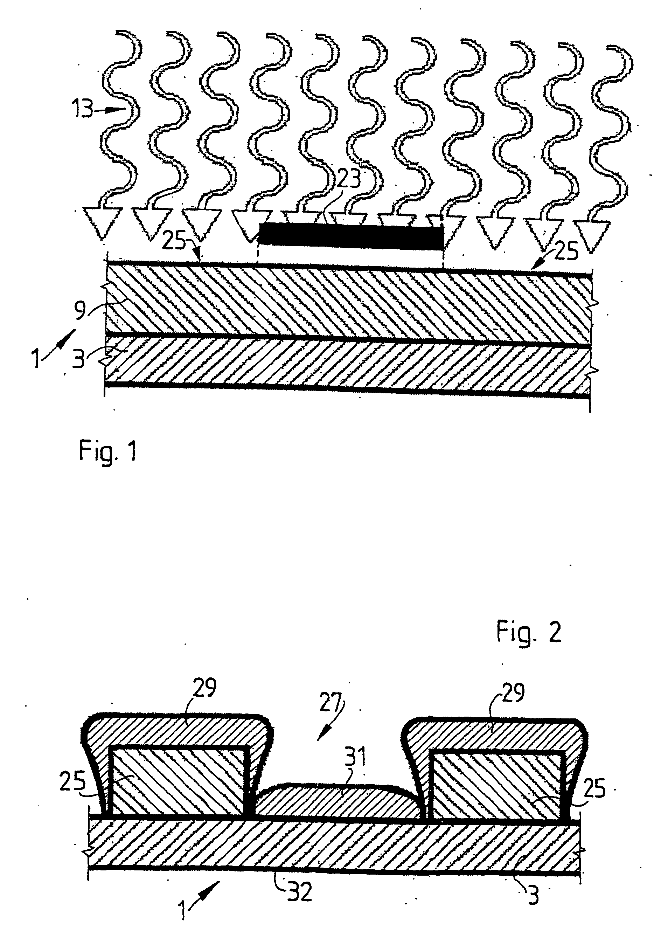

Figur 1 zeigt eine Einheit **1** mit einer Grundschicht **(3)**, auf er eine Photolackschicht **9** aufgetragen ist. Die Photolackschicht **9** hat eine Dicke von 3 µm bis 5 µm.

Die Auswahl des zu verwendenden Photolackes zur Herstellung der Lackschicht **9** ist von grosser Bedeutung. Ein Photolack mit den Eigenschaften eines Negativlackes führt bei der Oberflächenstrukturierung zu Seitenwänden mit negativer Steigung, d.h. zu überhängenden Wänden. Dies ergibt sich dadurch, dass die Intensität des für die Belichtung verwendeten Lichts (Strahlung) je tiefer sie in den Photolack eindringt desto stärker absorbiert wird. Diese überhängenden Wände sind beim "Lift-Off-Verfahren" erwünscht, da dann die Beschichtung an den Strukturrändem Diskontinuitäten aufweist, welche eine Entfernung der mit einer unten beschriebenen Beschichtung versehenen, entwickelten Photolackschichtgebiete (Opferschichtgebiete) erleichtert. Dieses Argument würde für die Verwendung eines Negativlackes sprechen.

Nachteilig bei der Verwendung eines Negativlackes ist jedoch dessen Tendenz, beim Aufschleudern Fäden zu ziehen, was eine schlechte Lackhomogenität der aufgebrachten Schicht nach sich ziehen kann. Ein Positivlack hingegen lässt einfach aufschleudern; führt allerdings, wie oben ausgeführt, nicht zu überhängenden Seitenwänden. Sind keine überhängenden Seitenwände der Strukturierung vorhanden, so erfolgt die Beschichtung kontinuierlich an den Strukturrändem und der spätere "Lift-Off"-Schritt wird erschwert.

Es wird beispielsweise ein Photolack mit der Bezeichnung Ti35E der Firma Micro Chemicals verwendet. Dies ist ein sogenannter Bildumkehrlack (image reversal resist IRR). Dieser Photolack hat, wie durch Versuche ermittelt wurde, die besondere Eigenschaft, dass er, nachdem er lokal aufgelöst entsprechend der gewünschten Oberflächenstrukturierung belichtet und anschliessend erhitzt wurde, nochmals belichtet werden kann. Durch diese zweite Belichtung, welche in der Regel als homogene Belichtung mit starker Intensität (Flutbelichtung) ausgeführt wird, erhält der Photolack für die nachfolgende Entwicklung die Charakteristika eines Negativlackes, wodurch überhängende Seitenwände der Strukturierung erhalten werden.

Die für eine vorgegebene Oberflächenendstrukturierung angepasste maskierte Belichtung **13** der Photolackschicht **9** des zweiten Verfahrensschrittes, wie in **Figur 1** schematisch angedeutet, erfolgt unter Verwendung einer Photomaske **23.** Es kann hierzu beispielsweise eine sogenannte Grauverlaufsmaske verwendet werden. Es können aber auch Phasenmasken in Kombination mit einer entsprechenden Lichtquelle zur Anwendung kommen.

In dem hier beschriebenen Beispiel wird eine Chrommaske **23** als Photomaske verwendet. Der auf der Grundschicht **3** der Einheit **1** liegende Photolack **9** wird mit der Strahlung **13** einer Quecksilberdampflampe bestrahlt. Die Strahlung **13** hat eine intensive Emissionslinie bei 365 nm. Die Intensität beträgt etwa 160 mJ/cm².

Die benötigte Belichtungszeit hängt im allgemeinen von der gewünschten Struktur, der verwendeten Strahlungsquelle (Lichtquelle) und gegebenenfalls von der verwendeten Photomaske ab.

Nach der "strukturierenden" Belichtung (erste Belichtung) wird die Einheit 1 mit dem auf der Schicht **3** befindlichen belichteten Photolack **9** bei 110 °C bis 130 °C "ausgebacken". Anschliessend erfolgt eine weitere Belichtung mit der Strahlung einer Quecksilberdampflampe (im Wesentlichen mit einer Wellenlänge der Strahlung von 365 nm) und einer Intensität von etwa 400 mJ/cm². Der hier verwendete Photolack Ti35E erhält nun durch diese zweite Belichtung (Bestrahlung) die Eigenschaften eine Negativlackes.

An diese zweite Belichtung schliesst sich ein Entwicklungsschritt als dritter Verfahrensschritt an. Hierzu lässt man 1,2%-ige NaOH-Lösung einwirken. Bei dieser Einwirkung bleiben die bei der ersten Belichtung belichteten Gebiete **25** der Photolackschicht **9** erhalten und bilden somit eine Oberflächenanfangsstrukturierung. Die hier angegebene Konzentration der Lösung von 1,2% gilt nur als Richtwert und ist den gegebenen Umständen, wie beispielsweise Photolackdicke und Belichtungsintensität, anzupassen.

Im folgenden vierten Verfahrensschritt, dessen Ergebnis die **Figur 2** zeigt, wird die Oberflächenanfangsstrukturierung mit verbliebenen Gebieten **25** und die durch die Entwicklung entfernten Gebiete **27** mit einer Beschichtung versehen. Die Beschichtungsbereiche auf den Gebieten **25** sind mit **29** und die in den Gebieten **27** mit **31** gekennzeichnet, obwohl es sich um ein und dasselbe Material handelt. Beispielsweise wird hier ein ca. 1 µm bis 2 µm dickes Wechselschichtsystem aufgesputtert. Auf die zu verwendenen Materialien ist bereits eingangs hingewiesen worden. Sputtern ist gegenüber anderen möglichen Beschichtungsverfahren gut geeignet, da niedrige Betriebstemperaturen, hier von beispielsweise unter 120 °C, an der Einheit **1** eingehalten werden können und die Beschichtung dennoch zu einem stabilen, insbesondere temperaturstabilen Wechselschichtsystem führt.

Nach dem Beschichten liegen auf der Grundschicht **3** Gebiete bestehend aus einem Photolackteilgebiet **25** bedeckt mit der Beschichtung **29** und Grundschichbereiche **3** bedeckt nur mit der Beschichtung **31,** deren Zusammensetzung identisch zu derjenigen der Beschichtung **29** ist. Das Oberflächenprofil entspricht im Wesentlichen der Oberflächenanfangsstrukturierung.

Anschliessend an diese Beschichtung erfolgt eine Energiebeaufschlagung der Einheit **1** von der Rückseite **32** aus. Die Energiebeaufschlagung erfolgt mit einer UV-Lichtbestrahlung, einer sogenannten Flutbelichtung mit, wie eingangs bereits erwähnt, 500 mJ bis 1500mJ/cm² während 4 bis 10 Minuten. Diese Behandlung führt zu einer zumeindest teilweisen Destabilisierung des Schichtsystems bestehend aus dem jeweiligen Photolackteilgebiet **25** und der darüberliegenden Beschichtung **29**.

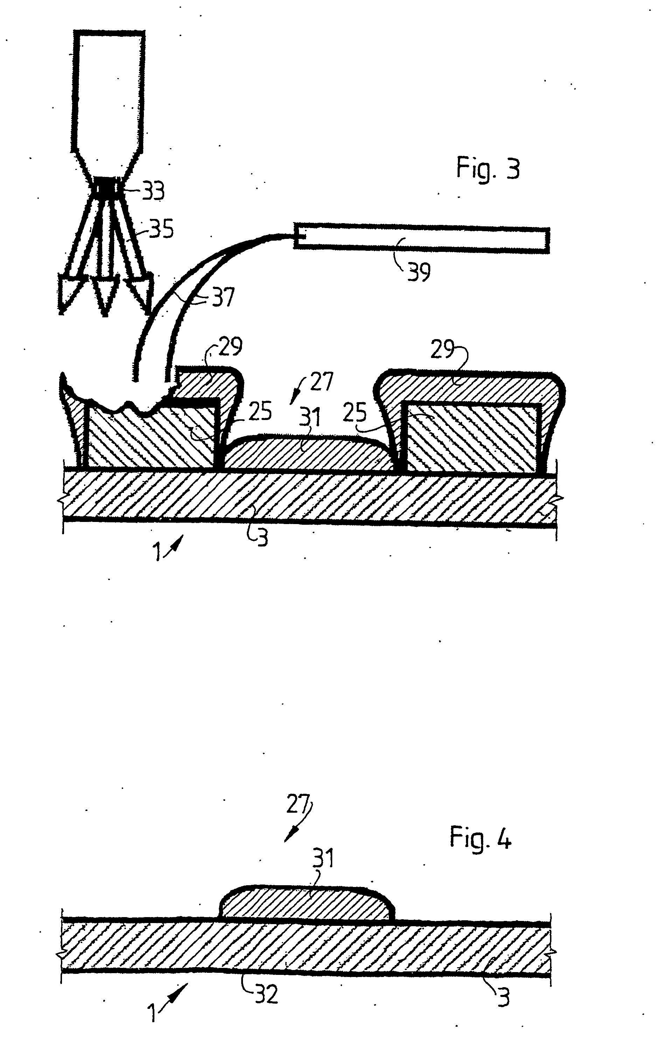

In einem sechsten Verfahrensschritt, dem sogenannten "Lift-Off-Prozess", sollen nun die Photoschichtteilgebiete **25**, welche die Beschichtung **29** tragen, entfernt werden. Um diese durch die Energiebeaufschlagung bereits destabilisierten Gebiete zu entfernen, wird, wie in **Figur 3** angedeutet, die Oberflächenanfangsstrukturierung mit einem aus einer Hochdruckdüse **33** austretenden Hochdruckwasserstrahl **35** beaufschlagt. Durch diese Beaufschlagung gelingt es nun in überraschender Weise die Beschichtung **29** von dem Photolackteilgebiet **25** zu lösen, ohne dass die Beschichtung **31** in den photolackfreien Gebieten angegriffen wird. Die Photolackteilgebiete **25** haben somit als Opferschichtgebiete gewirkt. Bei der Hochdruckdüse **33** handelt es sich um eine handelsübliche Düse; gearbeitet wird mit einem Druck im Bereich von 100 bar bis 180 bar. Bei einem Druck unterhalb 100 bar ist der Auflösungseffekt zu schwach und bei einem Druck über 180 bar ergibt sich möglicherweise eine zu hohe Temperatur.

Für den Hochdruckflüssigkeitsstrahl kann eine Vielzahl von Flüssigkeiten verwendet werden. Aufgrund der vorteilhaften Eigenschaften von DI-Wasser (entmineralisiertes, gefiltertes Wasser) wird jedoch dieses vorzugsweise eingesetzt, da es kostengünstig in hoher Qualität verfügbar ist und bei der Anwendung keine Rückstände zurück bleiben. Es ist zudem technischen einfach, den Betrieb einer Hochdruckdüse mit DI-Wasser aufrecht zu erhalten, da die mechanischen Bestandteile einer Vorrichtung zur Durchführung des Verfahrens nicht oder nur geringfügig angegriffen werden. Ergänzend sei bemerkt, dass die Verwendung von DI-Wasser umwelttechnisch keinerlei Probleme mit sich bringt.

Nach der Beaufschlagung mit dem Hochdruckflüssigkeitsstrahl **35** kann ein einfaches Lösungsmittel **37** z.B. NaOH-Lösung, wie in **Figur 3** angedeutet, auf die angegriffende Oberflächenanfangsstrukturierung gebracht werden, um die restlichen Teile der Photlackteilbereiche **25** und der Beschichtung **29** zu entfernen. Nach dieser Entfernung ist die Oberflächenendstrukturierung vorhanden. Das Lösungsmittel **37** wird in Figur **3** durch ein vom Hochdruckflüssigkeitsstrahl **33** getrenntes Zuführsystem **39** zugeführt; es kann aber auch zusammen mit dem Hochdruckflüssigkeitsstrahl **33** zugeführt werden. Die Zuführung des Lösungsmittels **37** kann nun gleichzeitig mit der Hochdruckflüssigkeit oder zeitlich unmittelbar nach dieser erfolgen. Der Hochdruckflüssigkeitsstrahl kann auch eine Flüssigkeit umfassen, die ein Lösungsmittel für den Photolack ist, aber die Einheit **1** [Einheit gemäss Verfahrensschritt 2 (Figur 2: Entwickelte Photolackschicht mit nachfolgender beispielsweiser Wechselschichtbeschichtung **29/31**)] und die Strukturierungsapperatur nicht merklich angreift.

In einem letzten Verfahrensschritt - es könnte ja sein, dass eventuell Seitenwände der Oberflächenstruktur stehen geblieben sind - kann nochmals mit dem Hochdruckwasserstrahl **33** die Oberflächenstruktur, d.h. die Oberflächenendstruktur, abgesprüht werden. Es erfolgt hierdurch eine Reinigung von eventuell noch verbliebenen unerwünschten Beschichtungsresten. Zurück bleibt analog **Figur 4** eine strukturierte Einheit (mit Oberflächenendstrukturierung, wobei Höhen und Tiefen zur Oberflächenanfangsstrukturierung vertauscht sind). Durch den Einsatz von DI-Wasser ist die Einheit gleichzeitig gereingt und bereit für einen nächsten Prozessschritt, der durchaus ein weiterer Lithografieprozess sein kann. Nach der Reinigung sollten die Einheiten feucht gehalten werden und erst später getrocknet werden, um eine Bildung von Trocknungsflecken zu vermeiden.

Die Grösse der Strukturen ist nach oben hin lediglich durch die Grösse der Einheit sowie der Maske für die Belichtung limitiert. Grössere Strukturgrössen werden mittels Grauverlaufsmasken und/oder Chrommasken im Mikrometer-Bereich realisiert. Für kleinere Strukturen werden Interferenzeffekte, z.B. von Phasenmasken eingesetzt. Für Strukturgrössen bis hinunter zu 10 nm kann ein Elektronenstrahlschreiben eingesetzt werden.

Anstatt den Photolack mit einer Quecksilberdampflampe unter Verwendung einer Chrommaske **23** entsprechend der geforderten Oberflächenstrukturierung zu bestrahlen, kann auch ein entsprechend der vorgegebenen Strukturierung über die Photolackschicht bewegter Laserstrahl verwendet werden. Auf die Chrommaske **23** kann dann verzichtet werden. Mit dem Laserstrahl können ebenfalls die oben erwähnten überhängenden Wände der Struktur erreicht werden. Es kann hierzu dem Laserstrahl ein entsprechendes Intentsitätsprofil über den Strahlquerschnitt aufgeprägt werden. Die Aufprägung des Intenstätsverlaufes über den Strahlquerschitt kann mit entsprechenden teildurchlässigen Blenden, einer ausgewählten Modenstruktur des Laserstrahls bzw. einer ausgewählten Fokussiertiefe der Fokussieroptik erreicht werden.

Wird beispielsweise ein Laserstrahl auf einen Bereich oberhalb des Photolacks mit einer kleinen Tiefenschärfe fokussiert, so wird sich dieser Laserstrahl stark divergierend im Photolack ausbreiten. Tiefer liegende Bereiche werden dadurch weniger stark belichtet als Bereiche die näher an der Photolackoberseite liegen; überhängende Seitenwände der Struktur werden dann nach dem Entwickeln erhalten.

Anstelle mit einem Laserstrahl kann auch mit einem Elektronenstahl die vorgegebene Struktur eingeschrieben werden. Es kann auch eine sogenannte Zweistrahlinterferenz zur Belichtung der Photolacksicht verwendet werden.

Anstatt die Energiebeaufschlagung zur Destabilisierung mit UV-Licht von der Rückseite **32** der Einheit **1** vorzunehmen, kann selbstverständlich auch von der Vorderseite her bestrahlt werden. Auf die Vorteile einer rückseitigen Bestrahlung, wie auch anderer Energiebeaufschlagungen ist bereits eingangs eingegangen worden.

Wird zur Energiebeaufschlagung die Einheit "gekocht" oder im Wasserdampf erhitzt, so hat es sich als vorteilhaft in Verstärkung der Destabilisierung erwiesen, einen nachgängigen Abschreckungsvorgang mit kaltem Wasser vorzunehmen. Hierbei hat sich gezeigt, dass der Ausdehnungseffekt des Image Reversal Lacks von Micro Chemicals höher ist als derjenige eines Standard Negativlacks (z.B. Azlof2035 von Clariant). Der gewählte Photolack von Micro Chemical zeigt somit eine bessere Wirkung.

Die oben erwähnte Beaufschlagung mit einem einfachen Lösungsmittel (NaOH) zur Entfernung noch stehen gebliebener Photloackteilgebiet mit einer eventuellen Teilbeschichtung (Teile von **29)** kann in einer besonders vorteilhaften Variante bereits mit dem "aufbrechenden" Hochdruckflüssigkeitsstrahl **33** zusammen oder kurz nach dessen Abschalten erfolgen. Da nun die Photolackteilgebiete wenigstens teilweise frei liegen, löst sich der Photolack bei Kontakt mit der NaOH-Lösung rasch auf.

Im Gegensatz zu bekannten Verfahren wird hier unter Verwendung eines Hochdruckflüssigkeitsstrahls beim "Lift-Off-Verfahren" auf ein aggressives Lösungsmittel verzichtet und lediglich nur ein schwaches Lösungsmittel oder sogar nur Wasser verwendet. Es kann zudem zum mechanischen Aufbrechen eine andere Flüssigkeit verwendet werden als zur Entfernung bzw. Auflösung der durch die Photoschichtteilgebiete gebildeten "Opferschicht". Das mechanische Aufbrechen ist allerdings, wie hier beschrieben, nur dann mit vertretbaren Aufwand möglich, wenn vorgängig eine Destabilisierung vorgenommen worden ist.

## Patentansprüche

1. Verfahren ("Lift-Off-Verfahren") zur Herstellung einer Einheit **(1)** mit einer räumlichen Oberflächenendstrukturierung auf einer Grundschicht **(3)**, wobei auf der Grundschicht **(3)** in einem ersten Verfahrensschritt ein Photolack zur Erzeugung einer Photolackschicht **(9)** aufgebracht wird, eine, einer vorgegebenen Oberflächenendstrukturierung angepasste, maskierte Belichtung **(13)** der Photolackschicht **(9)** in einem zweiten Verfahrensschritt vorgenommen wird, in einem dritten Verfahrensschritt mittels Entwicklung Teile der Photolackschicht **(9)** entfernt werden, so dass eine Photolackteilgebiete **(25)** als Opferschichtgebiete aufweisende Oberflächenanfangsstrukturierung erhalten wird, in einem vierten Verfahrensschritt eine die nun erhaltene Oberflächenanfangsstrukturierung bedeckende Beschichtung **(29, 31)**, vorzugsweise als Wechselschichtsystem, aufgebracht, insbesondere aufgesputtert, wird, in einem fünften Verfahrensschritt eine Energiebeaufschlagung der Oberflächenanfangsstrukturierung zur Destabilisierung der Opferschichtgebiete **(25)** vorgenommen wird, in einem sechsten Verfahrensschritt die Oberflächenanfangsstrukturierung bei einer vorgegebenen Bearbeitungstemperatur mit einem Hochdruckflüssigkeitsstrahl **(33)** beaufschlagt wird, zumindest Teile der die Opferschichtgebiete **(25)** bedeckenden Beschichtung **(29)** zur Erzeugung der Oberflächenendstrukturierung mechanisch entfernt bzw. wenigstens aufgebrochen werden, wobei im sechsten Verfahrensschritt die Flüssigkeit des Hochdruckflüssigkeitsstrahls (**33**) bei der Betriebstemperatur während der Beaufschlagung eine vernachlässigbare chemische Reaktionsgeschwindigkeit und/oder physikalische Auflösungsgeschwindigkeit mit Materialien der Einheit (**1**) und/oder mit insbesondere organischen, Fluiddichtungsmitteln unterhalb einer Messgrenze hat.

2. Verfahren nach Anspruch 1, **dadurch gekennzeichnet, dass** in einem siebten Verfahrensschritt ein Lösungsmittel **(37)**, typischerweise Natronlauge NaOH mit einer Konzentration zwischen 1% und 20%, vorzugsweise zwischen 9,5% und 10,5%, insbesondere von 10 %, zur Materialentfemung zugänglicher Teile der Opferschichtgebiete **(25)** aufgebracht wird.

3. Verfahren nach Anspruch 2, **dadurch gekennzeichnet, dass** das Lösungsmittel **(37)** mit dem Hochdruckflüssigkeitsstrahl **(33)** gleichzeitig aufgebracht wird.

4. Verfahren nach Anspruch 2, **dadurch gekennzeichnet, dass** das Lösungsmittel **(37)** dem Hochdruckflüssigkeitsstrahl **(33)** direkt nachfolgend, vorzugsweise durch ein vom Hochdruckflüssigkeitsstrahl **(33)** getrenntes Zuführsysteme **(39)**, aufgebracht wird.

5. Verfahren nach einem der Ansprüche 1 bis 4, **dadurch gekennzeichnet, dass** als destabilisierende Energiebeaufschlagung im fünften Verfahrensschritt eine UV-Flutbelichtung verwendet wird.

6. Verfahren nach einem der Ansprüche 1 bis 5, **dadurch gekennzeichnet, dass** zur destabilisierenden Energiebeaufschlagung im fünften Verfahrensschritt Heissdampf mit vemachlässigbarer chemischer Reaktionsgeschwindigkeit, insbesondere Wasserdampf, vorzugsweise mit einer Druckbeaufschlagung, verwendet wird.

7. Verfahren nach einem der Ansprüche 1 bis 6, **dadurch gekennzeichnet, dass** zur destabilisierenden Energiebeaufschlagung im fünften Verfahrensschritt die Einheit **(1)** in einer diese nicht angreifende Flüssigkeit, insbesondere Wasser, gekocht wird.

8. Verfahren nach einem der Ansprüche 1 bis 7, **dadurch gekennzeichnet, dass** zur destabilisierenden Energiebeaufschlagung im fünften Verfahrensschritt eine aufwärmenden Mikrowellenstrahlung verwendet wird.

9. Verfahren nach einem der Ansprüche 5 bis 8, **dadurch gekennzeichnet, dass** nach der destabilisierenden Energiebeaufschlagung kalt abgeschreckt wird.

10. Verfahren nach einem der Ansprüche 1 bis 9, **dadurch gekennzeichnet, dass** als Photolack ein sogenannter Bildumkehrlack, vorzugsweise mit einer Schichtdicke von 0,1 µm bis 10 µm, insbesondere zwischen 3 µm und 5 µm, verwendet wird und nach der maskierten Belichtung **(13)** im zweiten Verfahrensschritt die Photolackschicht **(9)** erhitzt, vorzugsweise bei einer Temperatur zwischen 110 °C und 130 °C gebacken, und anschliessend in einem Zwischenschritt ein zweites Mal, vorzugsweise homogen mit einer starken Belichtung im nahen Ultraviolettbereich grösser 300 mJ/cm², belichtet wird.

11. Verfahren nach einem der Ansprüche 1 bis 10, **dadurch gekennzeichnet, dass** zur Belichtung des Photolacks **(9)** ein Lichtstrahl, insbesondere ein Laserstrahl, verwendet wird, dessen Intensitätsverlauf innerhalb der Photolackschicht **(9)** derart verformt wird, dass er sich im Photolack stark divergierend ausbreitet, in dem er auf die Photolackschichtoberseite fokussiert wird, um tiefer liegende Bereiche der Photolackschicht lokal weniger zu belichten als Bereiche in unmittelbarer Oberflächennähe.

12. Verfahren nach einem der Ansprüche 1 bis 11, **dadurch gekennzeichnet, dass** die Beschichtung **(29,31)** als Wechselschichtsystem aus wenigstens einem hoch- und einem niedrig brechenden Material aus wenigstens zwei unterschiedlichen Oxiden oder Oxinitriden aus den Gruppen IVA, IVB, VB des periodischen Systems besteht und eine Dicke zwischen 0,5 µm und 5 µm, vorzugsweise zwischen 1 µm und 2 µm, hat und die Temperatur der Einheit **(1)** während des vierten Verfahrensschrittes unter 120 °C gehalten wird.

13. Verfahren nach einem der Ansprüche 1 bis 12, **dadurch gekennzeichnet, dass** als Flüssigkeit für den Hochdruckflüssigkeitsstrahl **(35)** DI-Wasser, entmineralisiertes, gefiltertes Wasser, vorzugsweise mit einem Druck zwischen 1.10⁷ Pa (100 bar) und (180 bar), 1,8·10⁷ Pa und insbesondere mit einer Temperatur grösser 60°C, verwendet wird, damit die strukturierte Vorderseite gleichzeitig gereinigt und somit bereit für einen nächsten Verfahrensschritt z.B. für einem Lithographieprozess ist.

14. Verwendung des Verfahrens nach einem der Ansprüche 1 bis 13 zur Herstellung strukturierter dielektrischer Filme auf optischen Einheiten, wie strukturierte optische Farbfilter, insbesondere Farbräder.

## Claims

1. Method ("Lift-off method") for producing a unit (1) with three-dimensional final surface structuring on a base layer (3), wherein in a first method step a photoresist is applied to the base layer (3) in order to produce a photoresist layer (9), a masked exposure (13) of the photoresist layer (9), adapted to predetermined final surface structuring, is carried out in a second method step, in a third method step parts of the photoresist layer (9) are removed by means of development, so that initial surface structuring comprising photoresist partial regions (25) as sacrificial layer regions is obtained, in a fourth method step a coating (29, 31) covering the initial surface structuring now obtained is applied, in particular sputtered, preferably as an alternating layer system, in a fifth method step energy is applied to the initial surface structuring in order to destabilise the sacrificial layer regions (25), in a sixth method step a high-pressure liquid jet (33) is applied to the initial surface structuring at a predetermined processing temperature, at least parts of the coating (29) covering the sacrificial layer regions (25) are mechanically removed or at least broken up in order to produce the final surface structuring, wherein in the sixth method step the liquid of the high-pressure liquid jet (33) has a negligible chemical reaction rate and/or physical dissolution rate with materials of the unit (1) and/or with, in particular, organic fluid sealants below a measuring limit at the operating temperature during application.

2. Method according to Claim 1, **characterised in that** in a seventh method step a solvent (37), typically sodium hydroxide solution NaOH with a concentration between 1% and 20%, preferably between 9.5% and 10.5%, in particular of 10%, is applied in order to remove the material of accessible parts of the sacrificial surface regions (25).

3. Method according to Claim 2, **characterised in that** the solvent (37) is applied at the same time as the high-pressure liquid jet (33).

4. Method according to Claim 2, **characterised in that** the solvent (37) is applied directly following the high-pressure liquid jet (33), preferably applied by a feed system (39) which is separate from the high-pressure liquid jet (33).

5. Method according to any one of Claims 1 to 4, **characterised in that** a UV flood exposure is used as the destabilising energy application in the fifth method step.

6. Method according to any one of Claims 1 to 5, **characterised in that** in the fifth method step superheated steam with a negligible chemical reaction rate, in particular water vapour, is used for the destabilising energy application, preferably with pressurisation.

7. Method according to any one of Claims 1 to 6, **characterised in that** the unit (1) is boiled in a liquid which does not attack it, in particular water, for the destabilising energy application in the fifth method step.

8. Method according to any one of Claims 1 to 7, **characterised in that** heating microwave radiation is used for the destabilising energy application in the fifth method step.

9. Method according to any one of Claims 5 to 8, **characterised in that** cold quenching is carried out after the destabilising energy application.

10. Method according to any one of Claims 1 to 9, **characterised in that** a so-called image reversal resist, preferably with a layer thickness of 0.1 µm to 10 µm, in particular between 3 µm and 5 µm, is used as the photoresist, and the photoresist layer (9) is heated after the masked exposure (13) in the second method step, preferably baked at a temperature between 110°C and 130°C, and subsequently exposed a second time, preferably homogeneously with intensive exposure in the near ultraviolet region exceeding 300 mJ/cm², in an intermediate step.

11. Method according to any one of Claims 1 to 10, **characterised in that** a light beam, in particular a laser beam, is used to expose the photoresist (9), the intensity profile of which beam within the photoresist layer (9) is deformed such that it spreads out in a highly divergent manner in the photoresist **in that** it is focused on the top side of the photoresist layer so as to locally expose lower areas of the photoresist layer to a lesser extent than areas in the immediate vicinity of the surface.

12. Method according to any one of Claims 1 Lo 11, **characterised in that** the coating (29, 31), as an alternating layer system, consists of at least one high- and one low-retractive material of at least two different oxides or oxinitrides from the groups IVA, IVB, VB of the periodic table and is of a thickness between 0.5 µm and 5 µm, preferably between 1 µm and 2 µm, and the temperature of the unit (1) is maintained below 120°C during the fourth method step.

13. Method according to any one of Claims 1 to 12, **characterised in that** DI water, demineralised, filtered water, preferably at a pressure between 1.10⁷ Pa (100 bar) and 1.8.10⁷ Pa (180 bar), and in particular at a temperature exceeding 60°C, is used as the liquid for the high-pressure liquid jet (35), so that the structured front is simultaneously cleaned and therefore ready for a next method step, e.g. for a lithographic process.

14. Use of the method according to any one of Claims 1 to 13 to produce structured dielectric films on optical units, such as structured optical colour filters, in particular colour wheels.

## Revendications

1. Procédé (procédé "lift-off") pour la production d'une unité (1) comportant une structuration superficielle finale tridimensionnelle, sur une couche de base (3), sachant que, lors d'une première étape opératoire, une laque photosensible est déposée sur la couche de base (3) en vue d'engendrer une couche (9) de laque photosensible ; lors d'une deuxième étape opératoire, la couche (9) de laque photosensible est soumise à une illumination masquée (13) adaptée à une structuration superficielle finale préétablie ; lors d'une troisième étape opératoire, des parties de la couche (9) de laque photosensible sont éliminées par développement, ce qui procure une structuration superficielle initiale présentant des zones partielles (25) de laque photosensible en tant que zones de couche réactive ; lors d'une quatrième étape opératoire, un revêtement (29, 31) recouvrant la structuration superficielle initiale désormais obtenue est déposé, notamment par crépitement, de préférence sous la forme d'un système à couches alternées ; lors d'une cinquième étape opératoire, la structuration superficielle initiale est sollicitée par de l'énergie en vue de déstabiliser les zones (25) de la couche réactive ; lors d'une sixième étape opératoire, la structuration superficielle initiale est sollicitée par un jet (33) de liquide sous haute pression, à une température de traitement préétablie, et au moins des parties du revêtement (29) recouvrant les zones (25) de la couche réactive sont éliminées mécaniquement, ou au moins rompues pour engendrer la structuration superficielle finale, sachant que, durant la sixième étape opératoire, le liquide du jet (33) de liquide sous haute pression présente à la température de service, au cours de la sollicitation, une vitesse de réaction chimique négligeable et/ou une vitesse de résolution physique négligeable avec des matériaux de l'unité (1) et/ou avec des agents notamment organiques de densification du fluide, en deçà d'une limite de mesure.

2. Procédé selon la revendication 1, **caractérisé par le fait que**, lors d'une septième étape opératoire, un solvant (37) typiquement constitué d'une lessive de soude NaOH, avec une concentration située entre 1 % et 20 %, de préférence entre 9,5 % et 10,5 %, en particulier de 10 %, est déposé en vue de l'élimination matérielle de parties accessibles des zones (25) de la couche réactive.

3. Procédé selon la revendication 2, **caractérisé par le fait que** le solvant (37) est déposé en simultanéité avec le jet (33) de liquide sous haute pression.

4. Procédé selon la revendication 2, **caractérisé par le fait que** le solvant (37) est déposé en succession directe avec le jet (33) de liquide sous haute pression, de préférence par l'intermédiaire d'un système d'amenée (39) distinct dudit jet (33) de liquide sous haute pression.

5. Procédé selon l'une des revendications 1 à 4, **caractérisé par le fait qu'**une illumination par un flux UV est utilisée, lors de la cinquième étape opératoire, en tant que sollicitation par énergie déstabilisante.

6. Procédé selon l'une des revendications 1 à 5, **caractérisé par le fait que** de la vapeur chaude à vitesse de réaction chimique négligeable, en particulier de la vapeur d'eau, est de préférence utilisée avec une sollicitation par pression, lors de la cinquième étape opératoire, en vue de la sollicitation par énergie déstabilisante.

7. Procédé selon l'une des revendications 1 à 6, **caractérisé par le fait que** l'unité (1) est bouillie dans un liquide non agressif et notamment dans de l'eau, lors de la cinquième étape opératoire, en vue de la sollicitation par énergie déstabilisante.

8. Procédé selon l'une des revendications 1 à 7, **caractérisé par le fait qu'**un rayonnement de micro-ondes à effet de réchauffement est utilisé, lors de la cinquième étape opératoire, en vue de la sollicitation par énergie déstabilisante.

9. Procédé selon l'une des revendications 5 à 8, **caractérisé par** un brusque refroidissement à l'issue de la sollicitation par énergie déstabilisante.

10. Procédé selon l'une des revendications 1 à 9, **caractérisé par le fait qu'**on utilise, en tant que laque photosensible, une "laque d'inversion d'images" présentant, de préférence, une épaisseur de couche de 0,1 µm à 10 µm, notamment entre 3 µm et 5 µm et, après l'illumination masquée (13) lors de la deuxième étape opératoire, la couche (9) de laque photosensible est réchauffée, cuite de préférence à une température comprise entre 110°C et 130°C, puis illuminée une seconde fois dans l'enchaînement, lors d'une étape intermédiaire, de préférence de manière homogène avec une forte illumination dans la plage ultraviolette proche excédant 300 mJ/cm².

11. Procédé selon l'une des revendications 1 à 10, **caractérisé par le fait qu'**on utilise, pour l'illumination de la laque photosensible (9), un rayonnement lumineux revêtant notamment la forme d'un rayon laser dont le profil d'intensité est déformé, à l'intérieur de la couche (9) de laque photosensible, de façon telle qu'il se propage avec forte divergence, dans la laque photosensible, du fait qu'il est focalisé sur la face supérieure de la couche de laque photosensible, afin que des régions plus profondes de ladite couche de laque photosensible soient localement moins illuminées que des régions situées à proximité directe de la surface.

12. Procédé selon l'une des revendications 1 à 11, **caractérisé par le fait que** le revêtement (29, 31), se présentant comme un système à couches alternées, se compose d'au moins un matériau avec un indice de réfraction élevé et d'un matériau avec un indice de réfraction faible, en au moins deux oxydes ou oxynitrures différents provenant des groupes IVA, IVB, VB du système périodique, et présente une épaisseur située entre 0,5 µm et 5 µm, de préférence entre 1 µm et 2 µm, la température de l'unité (1) étant maintenue inférieure à 120°C lors de la quatrième étape opératoire.

13. Procédé selon l'une des revendications 1 à 12, **caractérisé par le fait qu'**on utilise, en tant que liquide destiné au jet (35) de liquide sous haute pression, de l'eau déminéralisée et filtrée présentant, de préférence, une pression comprise entre 1.10⁷ Pa (100 bar) et 1,8.10⁷ Pa (180 bar), et notamment une température supérieure à 60°C, de telle sorte que la face antérieure structurée soit simultanément nettoyée et soit ainsi prête pour une étape opératoire suivante, par exemple pour un processus lithographique.

14. Utilisation du procédé selon l'une des revendications 1 à 13, pour fabriquer des films diélectriques structurés sur des unités optiques telles que des filtres optiques colorés et structurés, en particulier des roues colorées.
